# EUROPÄISCHE PATENTANMELDUNG

(11) **EP 0 543 257 A2**
(43) Veröffentlichungstag der Anmeldung: **26.05.1993**
(21) Anmeldenummer: 92119217.5
(22) Anmeldetag: 10.11.1992
(51) Int. Cl.: H01L 21/336, H01L 29/06, H01L 29/784

(54) **Herstellverfahren für einen Leistungs-MISFET**

(30) Priorität: 13.11.1991 DE 4137341
(71) Anmelder: SIEMENS AKTIENGESELLSCHAFT, D-80333 München (DE)
(72) Erfinder: Strack, Helmut, Dr. phil., W-8000 München 40 (DE)

(57) **Zusammenfassung**

Es wird ein Herstellverfahren für einen Niedervolt-Leistungs-MISFET angegeben, der mit drei Masken (Fotoschritten) auskommt. Beim ersten Schritt wird eine Polysiliziumschicht (3) strukturiert und ein Zellenfeld und Randzonen hergestellt. Dann wird eine Oxidschicht (2) aufgebracht, die beim zweiten Fotoschritt über den Zellen und den Randzonen und zwischen dem Rand (4) und den Zellen geöffnet wird. Dann wird eine Metallschicht aufgebracht, die durch den dritten Fotoschritt zwischen den Zellen und dem Rand (4) unterbrochen wird. Damit werden Feldplatten und Kanalstopper (9) erzeugt. Als letzter Schritt wird eine schwach leitende Schicht (20) auf die gesamte Oberfläche aufgebracht.

## Beschreibung

Die Erfindung bezieht sich auf ein Verfahren zum Herstellen eines Leistungs-MISFET mit einem Halbleiterkörper, der ein Feld von Transistorzellen sowie mindestens eine Feldplatte und mindestens einen Kanalstopper aufweist.

Verfahren zum Herstellen solcher MISFET sind gängige Praxis. Dabei werden wenigstens vier, meistens jedoch fünf oder mehr Fotoschritte benötigt, um die feinen Strukturen eines solchen Leistungs-MISFET herzustellen. Für jeden Fotoschritt wird eine Maske benötigt. Eine signifikante Reduzierung der Herstellkosten läßt sich nur durch Verminderung der Fotoschritte erreichen.

Der Erfindung liegt die Aufgabe zugrunde, ein für einen Niedervolt-Leistungs-MISFET verwendbares Verfahren anzugeben, das mit lediglich drei Fotoschritten auskommt.

Dieses Verfahren ist gekennzeichnet durch die Schritte:
a) der Halbleiterkörper wird mit einer ersten Oxidschicht bedeckt,
b) die erste Oxidschicht wird mit einer Polysiliziumschicht bedeckt,
c) die Polysiliziumschicht wird durch einen ersten Fotoschritt strukturiert,
d) die Transistorzellen und übereinanderliegende Randzonen werden erzeugt,
e) der Halbleiterkörper wird mit einer zweiten Oxidschicht bedeckt,
f) durch einen zweiten Fotoschritt werden in der zweiten Oxidschicht im Bereich der Transistorzellen und der Randzonen Kontaktlöcher bzw. ein Kontaktbereich und zwischen den Transistorzellen und den Randzonen in der Polysiliziumschicht eine die Transistorzellen umgebende ringförmige Vertiefung erzeugt,
g) der Halbleiterkörper wird mit einer Metallschicht bedeckt,
h) die Metallschicht und die Polysiliziumschicht werden durch einen dritten Fotoschritt im Bereich der ringförmigen Vertiefung vollständig unterbrochen,
i) anschließend wird auf die Oberfläche eine schwach leitende Schicht aufgebracht.

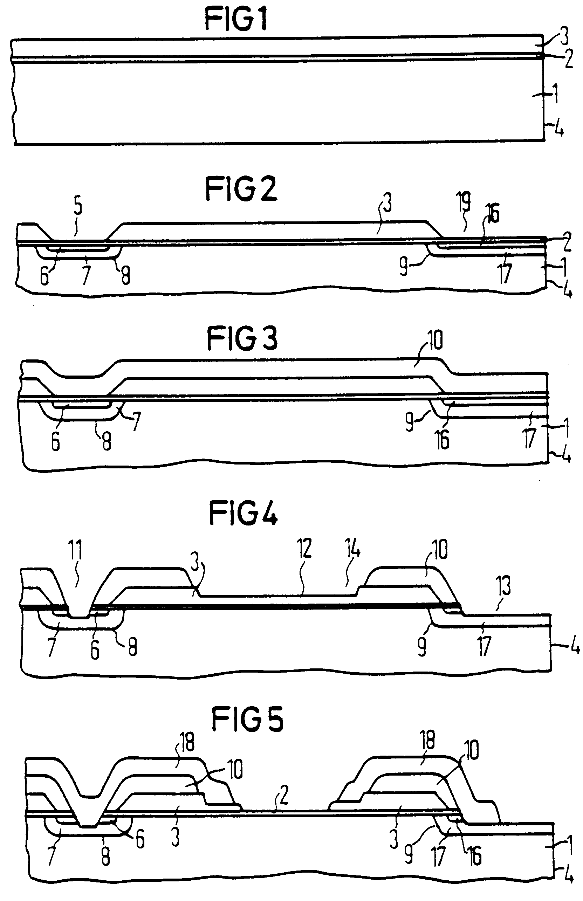

Die Erfindung wird anhand eines Ausführungsbeispiels in Verbindung mit den Figuren 1 bis 6 näher erläutert. Diese Figuren zeigen nicht alle, sondern nur die erfindungswesentlichen Verfahrensschritte. Gleiche Teile sind in den Figuren mit gleichen Bezugszeichen versehen.

In Figur 1 ist ein Halbleiterkörper gezeigt und mit 1 bezeichnet. Er ist z. B. schwach n-leitend. Der Halbleiterkörper wird mit einer Oxidschicht 2 bedeckt, die als Gateoxid verwendet wird. Anschließend wird die Schicht 2 mit einer Polysilizimschicht 3 bedeckt.

Die Polysiliziumschicht 3 wird in einem ersten Fotoschritt strukturiert, wobei Öffnungen 5 für die Transistorzellen und eine am Rand liegende Öffnung 19 für den Kanalstopper entstehen (Figur 2). Diese Öffnungen haben schräge Flanken, so daß die Polysiliziumschicht 3 als Maske für die Herstellung der Sourcezonen 6 und der Basiszonen 7 bzw. der übereinanderliegenden Zonen 16, 17 des am Rand 4 liegenden Kanalstoppers 9 dienen kann. Sourcezonen 6, Basiszonen 7 und die Zonen 16, 17 werden in bekannter Art und Weise z. B. durch Implantation von Arsen- oder Phosphorionen bzw. Borionen erzeugt. Die Energie der Borionen ist dabei größer, so daß diese auch den abgeschrägten Teil der als Maske verwendeten Polysiliziumschicht 3 durchdringen und tiefer in den Halbleiterkörper 1 eindringen. Bei diesem Schritt werden Transistorzellen 8 und die Zonen 16, 17 erzeugt.

Als nächster Schritt (Figur 3) wird eine zweite Oxidschicht 10 aufgebracht, die um ein Vielfaches dicker als die Oxidschicht 2 ist. Die Oxidschicht 10 bedeckt die gesamte Oberfläche des Halbleiterkörpers 1. In einem zweiten Fotoschritt wird die zweite Oxidschicht 10 strukturiert. Sie wird im Bereich der Transistorzellen 8 und der Zonen 16, 17 derart geöffnet, daß Kontaktlöcher 11 bzw. ein Kontaktbereich 13 entstehen, die bis zu den Basiszonen 7 bzw. zur Randzone 17 reichen. Beim gleichen Fotoschritt wird in der zweiten Oxidschicht 10 zwischen den Transistorzellen 8 und den Randzonen eine Öffnung 14 erzeugt, die die Transistorzellen 8 ringförmig umgibt. Der gleiche Ätzvorgang, der die Kontaktlöcher 11 und den Kontaktbereich 13 bis zur Oberfläche der Basiszonen 7 bzw. der Randzone 17 öffnet, ätzt auch eine ringförmige Vertiefung 12 in die Polysiliziumschicht 3.

Anschließend wird auf die Oberfläche des Halbleiterkörpers eine Metallschicht 18, z. B. aus Aluminium aufgebracht. Diese Schicht bildet die Sourcekontakte für die Transistorzellen 8 und schafft die für einen Leistungs-MISFET unentbehrlichen Nebenschlüsse zwischen den Sourcezonen 6 und Basiszonen 7. Im Bereich des Kanalstoppers 9 kontaktiert die Metallschicht 18 die Randzonen 16, 17.

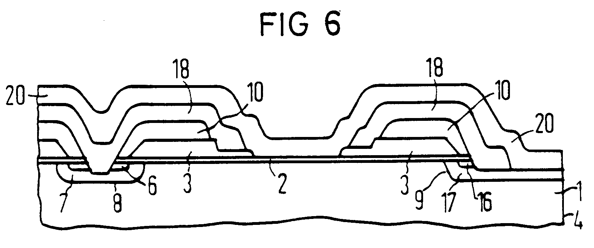

In einem dritten und letztem Fotoschritt wird die Polysiliziumschicht 3 und die Metallschicht 18 zwischen Zellen 8 und Kanalstopper 9 vollständig unterbrochen (Figur 5). Anschließend wird dann die gesamte Oberfläche mit einer schwach leitenden Passivierungsschicht, z. B. aus amorphen Silizium oder aus Siliziumnitrid bedeckt (Figur 6). Die Leitfähigkeit kann bei letzterer durch das Verhältnis von Silizium zu Stickstoff eingestellt werden.

Die mit den Transistorzellen 8 verbundene Metallschicht 18 wirkt zusammen mit dem mit ihr verbundenen Teil der Polysiliziumschicht 3 als Feldplatte. Die mit den Randzonen 16, 17 verbundene Metallschicht 18 wirkt in Verbindung mit der mit ihr verbundenen Polysiliziumschicht 3 als Kanalstopperelektrode. Da der die Randzone 17 begrenzende pn-Übergang durch seine Randlage infolge mechanischer Trennvorgänge z. B. durch Sägen sehr schlecht ist, ist hier ein relativ guter Kontakt zwischen dem Kanalstopper und dem Substrat des Halbleiterkörpers 1 gegeben. Die Zone 16 wirkt aus dem gleichen Grund auch nicht als Sourcezone. Durch die schwach leitende Schicht 20 wird eine gute Langzeitstabilität der Sperrkennlinien erreicht.

## Patentansprüche

1. Verfahren zum Herstellen eines Leistungs-MOSFET mit einem Halbleiterkörper, der ein Feld von Transistorzellen sowie mindestens eine Feldplatte und mindestens einen Kanalstopper aufweist,
**gekennzeichnet durch** die Schritte:
a) der Halbleiterkörper (1) wird mit einer ersten Oxidschicht (2) bedeckt,
b) die erste Oxidschicht wird mit einer Polysiliziumschicht (3) bedeckt,
c) die Polysiliziumschicht wird durch einen ersten Fotoschritt strukturiert,
d) die Transistorzellen (8) und übereinanderliegende Randzonen (16, 17) werden erzeugt,
e) der Halbleiterkörper wird mit einer zweiten Oxidschicht (10) bedeckt,
f) durch einen zweiten Fotoschritt werden in der zweiten Oxidschicht im Bereich der Transistorzellen (8) und der Randzonen (16, 17) Kontaktlöcher (11) bzw. ein Kontaktbereich (13) und zwischen den Transistorzellen (8) und den Randzonen (16, 17) in der Polysiliziumschicht eine die Transistorzellen umgebende ringförmige Vertiefung (12) erzeugt,
g) der Halbleiterkörper wird mit einer Metallschicht (18) bedeckt,
h) die Metallschicht (18) und die Polysiliziumschicht (3) werden durch einen dritten Fotoschritt im Bereich der ringförmigen Vertiefung (12) vollständig unterbrochen,
i) anschließend wird auf die Oberfläche eine schwach leitende Schicht (20) aufgebracht.

2. Verfahren nach Anspruch 1,
**dadurch gekennzeichnet,** daß als schwach leitende Schicht (20) amorphes Silizium aufgebracht wird.

3. Verfahren nach Anspruch 2,
**dadurch gekennzeichnet,** daß als schwach leitende Schicht (20) Siliziumnitrid aufgebracht wird.
